# EUROPEAN PATENT SPECIFICATION

(11) **EP 0 380 318 B1**
(45) Date of publication and mention of the grant of the patent: **12.10.1994**
(21) Application number: 90300733.4
(22) Date of filing: 24.01.1990
(51) Int. Cl.: H01L 39/24, H01B 12/04

(54) **Process for making superconducting wires**
Verfahren zur Herstellung von supraleitenden Drähten
Procédé pour la fabrication de fils supraconducteurs

(30) Priority: 25.01.1989 US 301444
(43) Date of publication of application: 01.08.1990
(73) Proprietor: UNIVERSITY OF ARKANSAS, Fayetteville, Arkansas 72701 (US)
(72) Inventor: Hermann, Allen M., Dr., Fayetteville, Arkansas 72701 (US); Sheng, Zhengzhi, Dr., Fayetteville, Arkansas 72701 (US); Shams, Q.A., Dr., Fayetteville, Arkansas 72701 (US)
(74) Representative: Sheard, Andrew Gregory

(56) References cited:
- EP-A- 0 280 292
- EP-A- 0 305 179
- GB-A- 2 220 426
- PATENT ABSTRACTS OF JAPAN vol. 013, no. 259 (E-773) 15 June 1989 & JP-A-01 054623
- PATENT ABSTRACTS OF JAPAN vol. 013, no. 248 (E-770) 09 June 1989 & JP-A-01 050319

## Description

The present invention relates to a superconducting wire, and a process for the fabrication of high temperature superconducting wire.

A variety of superconducting systems are known, as well as methods for making same. In trying to create a superconducting system, one concern is trying to provide a superconducting system that will provide a superconductor that can be fabricated into a usable shape, such as, for example, a wire.

EP-A-0305179, in the name of the applicants in the present application, discloses processes for making superconductors. More specifically, the patent application discloses a melt process based on molten barium-copper-oxides which allows high-quality R-Ba-Cu-O superconductors (wherein R is chosen from the group of rare earth metals excluding Tb, Pr, and Ce) to be easily constructed. The process can be utilised to make R-Ba-Cu-O superconductors in an arbitrary shape.

Other processes for making R-Ba-Cu-O superconductors have been reported. Some processes for making R-Ba-Cu-O superconducting wires have also been reported. These processes have not been entirely satisfactory because of low critical current densities and poor mechanical properties.

An improved superconducting wire and an improved process for making R-Ba-Cu-O superconducting wires is desirable for many reasons. Such a product and process could: (1) provide high-quality R-Ba-Cu-O superconducting wires; (2) provide superconducting wires that possess unique properties suitable to various special applications; (3) provide low cost processing and manufacturability; and (4) provide a guide to the manufacture of new higher temperature superconducting wires that may be discovered in the future.

According to a first aspect of the present inventions there is provided a process for the preparation of a wire, the process comprising contacting a metal wire comprising Y, Sm, Eu, Gd, Dy, Ho, Er, Tm, Yb or Lu, that has been oxidized, with a barium-copper-oxide.

The barium-copper-oxide is preferably molten so that the oxidised metal wire is coated with the barium-copper-oxide. Suitably the oxidation of the metal wire results in a surface layer of metal oxide that consists of the elements oxygen and the metal and is substantially free of all other elements, that is to say it is substantially free of complex oxides. The metal is preferably yttrium (Y), but can also be Sm, Eu, Gd, Dy, Ho, Er, Tm, Yb and Lu, collectively designated X.

Thus the present invention provides an improved superconducting wire and process for making X-Ba-Cu-O superconducting wires. The process may include the reaction of a molten barium-copper-oxide with a rare earth oxide.

In a preferred embodiment of the process of the present invention, the X-Ba-Cu-O superconducting wires are produced in approximately three steps: (1) oxidation of the metal wire (X); (2) preparation and melting of a barium-copper-oxide mixture; and (3) contacting, eg. by coating, the molten barium-copper-oxide mixture with the oxidized metal wire. Advantageously the process includes additionally annealing the (coated) metal wire.

Pursuant to the process of the present invention, superconducting wires can also be produced utilising: Sm; Eu; Gd; Dy; Ho; Er; Tm; Yb; and Lu wires that are oxidised and coated with barium-copper-oxides.

Pursuant to the present invention, a superconductor is created at an interface layer of the barium-copper-oxide layer and the metal oxide layer. Therefore, the present invention provides a superconducting wire that can include a protective barium-copper-oxide layer.

Preferably the barium-copper-oxide has a nominal composition represented by the general formula BaₓCu_{y}O_{z} wherein: 0<x<10; 0<y<10; and x+y-1<z<x+y+2. Preferably x=1 or 2, y=3 and z=4 or 5.

The oxidised metal wire may have the nominal composition: X₂O₃ eg. Y₂O₃.

The present invention may provide a process for the preparation of high quality X-Ba-Cu-O superconducting wire, as well as wire made therefrom. The process preferably includes coating molten barium-copper-oxide onto an oxidised Y, Sm, Eu, Gd, Dy, Ho, Er, Tm, Yb, or Lu metal wire.

Thus in a preferred embodiment of the process for the preparation of a X-Ba-Cu-O superconducting wire, the process comprises (1) oxidising a yttrium wire; (2) preparing a mixture of barium-copper-oxide and melting same; (3) coating the oxidised yttrium wire with the molten barium-copper-oxide. The process preferably includes the step of annealing the coated yttrium wire.

Thus the process of the present invention may provide high quality Y-Ba-Cu-O superconducting wires. Moreover, the process may provide a simple, and relatively low cost, procedure for processing and manufacturing Y-Ba-Cu-O superconducting wires.

Pursuant to the process of the present invention, a barium-copper-oxide mixture is prepared. The barium-copper-oxides are preferably prepared from an oxide and/or carbonate compound of barium and copper, for example by grinding and mixing either BaCO₃ and CuO or BaO and CuO. Suitably the molar ratio of barium to copper, in the barium-copper-oxide mixture, is from 1:3 to 2:3. It has been found that these oxides have the lowest melting points.

Preferably, after the grinding and mixing step, the powder is heated. Preferably the barium-copper-oxide powder is heated in an atmospheric environment at a temperature of from 900 to 1000°C, eg. at approximately 900°C for about 12 hours (or longer if necessary).

Thus the barium-copper-oxide resultant powder preferably has the following general formula:

BaₓCu_{y}O_{z}

wherein: 0<x<10; O<y<10; and x+y-1<z<x+y+2.

After the barium-copper-oxide powder has been prepared, it is then preferably melted and coated onto an oxidised yttrium wire. The yttrium wire is produced by extrusion from 1 mm thick Y wire (available from Aesar Company). As previously stated, Sm, Eu, Gd, Dy, Ho, Er, Tm, Yb, and Lu wires can also be used and a variety of well known methods can be used to produce these wires in arbitrary length, thickness, and shape. The normal yttrium metal wire has a resistance of about 5 ohms for 50.8 mm (2 inches) length, 1 mm thick at room temperature.

To prepare an oxidised metal wire, the wire is preferably heated in flowing oxygen, suitably at 500-800°C, for example for at least 12 hours, eg. about 14 hours. After the oxidation process, if the yttrium wire is used the yttrium oxide (Y₂O₃) on the core provides a resistance on the order of mega ohms.

In order to coat the oxidised metal wire with barium-copper-oxide, the barium-copper-oxide powder is melted. The barium-copper-oxide powder can be melted by being heated in a furnace preferably at about 1000°C, either alone or in a quartz boat. The oxidised metal wire may then be coated with the molten barium-copper-oxide by being dipped in the barium-copper-oxide melt. The wire is preferably dipped for from 10 to 20 seconds, eg. about 15 seconds. This time has been found to be sufficient to coat a barium-copper-oxide melt onto an oxidised yttrium wire.

In a preferred process of the present invention, after the wire is coated, it is then annealed in flowing oxygen. For example, the coated wire may be annealed in flowing oxygen at approximately 900±5°C for approximately 12 hours, followed by a furnace cooling.

After the wire is coated, it may be desirable to scratch or etch the surface of the coated wire to access or reach an interface layer between the barium-copper-oxide and metal oxide. It is this interface which is superconducting and preferably has the general formula XBa₂Cu₃O₇₋ₓ. Alternatively, the excess barium-copper-oxide could be removed mechanically while it is in the molten state.

For example, in one embodiment of the present invention, due to the layer of the BaCu₃O₄ at the surface of the wire, it may be necessary to scratch off some of the BaCu₃O₄ to reach the interface of the BaCu₃O₄ and Y₂O₃. The interface layer, which is superconducting, has the structure YBa₂Cu₃O₇₋ₓ. In the examples set forth below, it is at this interface layer that connections were made for resistance measurement.

A particularly preferred process of the present invention for making a high temperature superconducting wire comprises:
a. grinding a mixture of barium and copper which is BaCO₃ and CuO, or BaO and CuO;
b. heating the ground mixture to obtain a BaₓCu_{y}O_{z} powder, eg. at about 900°C for 12 hours;
c. oxidising a yttrium wire, eg. at from 500-800°C especially about 800°C for about 12 hours;
d. melting the BaₓCu_{y}O_{z} mixture;
e. coating of oxidised yttrium wire with molten BaₓCu_{y}O_{z};
   where
   0<x<10;
   0<y<10; and
   x+y-1<z<x+y+2.

Preferred compositions are Ba₂Cu₃O₅ and BaCu₃O₄.

Preferably the mixture in (d) is placed in a boat and heated until it is completely melted. The process may additionally include dipping the oxidised yttrium wire in molten BaₓCu_{y}O_{z} for approximately 10 to about 20 seconds.

According to a second aspect of the present invention there is provided a superconducting wire comprising:
a metal oxide first layer (eg. coating), the metal being Y, Sm, Eu, Gd, Dy, Ho, Er, Tm, Yb or Lu;
a metal core;
a barium-copper-oxide second layer (eg. coating), outside the first layer;
a superconducting layer located at an interface between the first and second layers.

The first and second layers are preferably adjacent layers, and the interface layer preferably has the formula YBa₂Cu₃O₇₋ₓ, where 0<x<10. The wire of the second aspect is preferably made by the process of the first aspect, mutatis mutandis.

Accordingly, one advantage of the present invention is that it may provide a process for producing high-quality X-Ba-Cu-O superconducting wires.

A further advantage of the present invention is that it may provide a process for fabricating X-Ba-Cu-O superconducting wires without the need for sophisticated equipment.

A still further advantage of the present invention is that it may provide a process for continuously fabricating X-Ba-Cu-O superconducting wires.

Another advantage of the present invention is that X-Ba-Cu-O superconducting wires may be fabricated that have a core comprising, eg. constructed from, a normal metal.

Furthermore, an advantage of the present invention is that X-Ba-Cu-O superconducting wires may include a barium-copper-oxide coating layer that protects the superconducting layer from degradation.

Additional features and advantages of the present invention are described in, and will be aparent from, the detailed description of the presently preferred embodiments and from the drawings.

The invention will now be described by way of example, which are not to be construed as limiting, with reference to the accompanying drawings, in which:
Figure 1 is a graph of electrical resistance versus temperature of a Y-Ba-Cu-O superconducting wire made in accordance with the present invention;
Figure 2 is a graph of electrical resistance versus temperature of a Y-Ba-Cu-O superconducting wire made in accordance with the present invention:
Figure 3 is a graph of electrical resistance versus temperature of a Y-Ba-Cu-O superconducting wire made in accordance with the present invention.

By way of example and not limitation, examples of the method of the present invention for making high-quality X-Ba-Cu-O superconducting wires will now be given:

### Example 1:

A. The following reagents were utilized:
   1. BaCO₃;
   2. CuO; and
   3. Yttrium metal wire.
B. The following procedure was followed:
   1. A mixture of a two molar portion of BaCO₃ and a three molar portion of CuO was ground with an agate mortar and pestle. The mixture was then heated in air at 900°C for more than 12 hours to obtain a uniform black Ba₂Cu₃O₅ powder.
   2. A yttrium wire was placed in a tube furnace for 12 hours at 800°C in flowing oxygen.
   3. The Ba₂Cu₃O₅ powder was placed in a boat, and the boat was placed in a furnace and heated at 1000°C for two hours. The powder was thereby melted. The yttrium wire was dipped into the molten solution for 15 seconds, to coat same, and taken out.
   4. The coated yttrium wire was then annealed for 12 hours at 900±5°C in flowing oxygen.

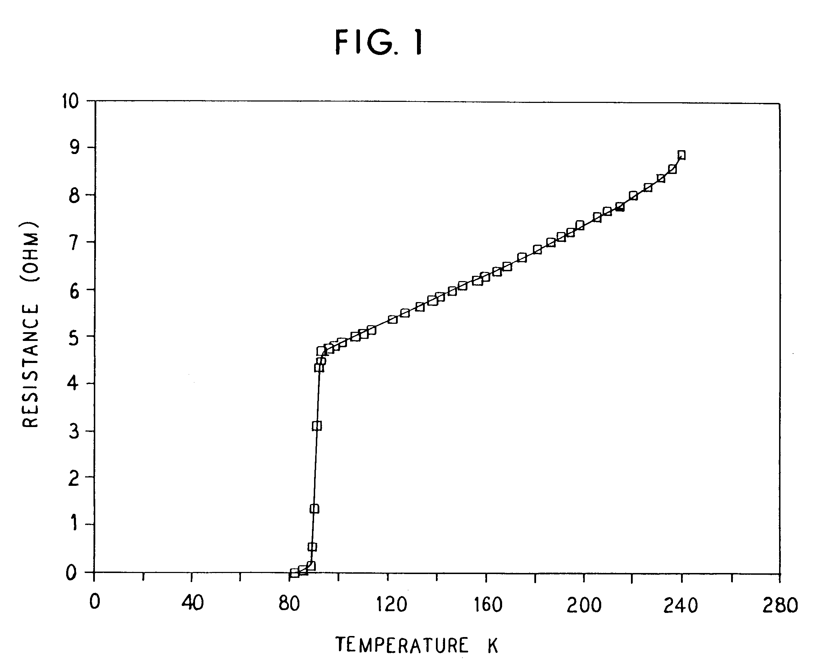

The wire, produced pursuant to this example, formed a superconductive layer under the Ba₂Cu₃O₅ coating. Figure 1 illustrates, graphically, the resistance of the Y-Ba-Cu-O wire made pursuant to this example, as a function of temperature. The resistance was measured at the interface layer of the Ba₂Cu₃O₅ and Y₂O₃. The wire reached zero resistance at 83 K.

### Example 2:

A. The following reagents were utilized:
   1. BaCO₃;
   2. CuO; and
   3. Yttrium metal wire.
B. The following procedure was followed:
   1. A mixture of a one molar portion of BaCO₃ and a three molar portion of CuO was ground with an agate mortar and pestle. The mixture was then heated in air at about 900°C for more than 12 hours to obtain a uniform black BaCu₃O₄ powder.
   2. A yttrium wire was placed in a tube furnace for 12 hours at 650°C in flowing oxygen. After oxidation, the yttrium wire provided a resistance on the order of megaohms.
   3. The BaCu₃O₄ powder was put in a boat, and heated in a furnace to 1000°C for two hours. The powder was thereby melted. The yttrium wire was dipped in this molten solution for 15 seconds, to coat same, and was then taken out.
   4. The coated yttrium wire was annealed for 12 hours at 900±5°C in flowing oxygen.

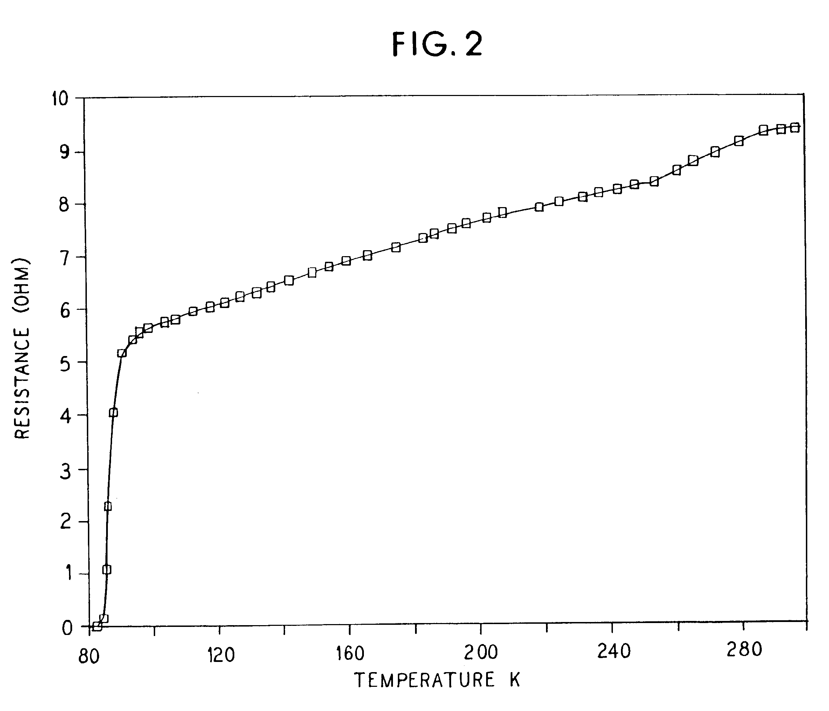

The wire prepared pursuant to this example, formed a superconductive layer under the BaCu₃O₄ coating. Figure 2 illustrates, graphically, the resistance as a function of temperature for a Y-Ba-Cu-O wire made pursuant to this example. The resistance was measured at the interface layer of the BaCu₃O₄ and Y₂O₃. The wire reached a zero resistance at 90 K.

### Example 3:

A. The following reagents were utilized:
   1. BaCO₃;
   2. CuO; and
   3. Yttrium metal wire.
B. The following procedure was followed:
   1. A mixture of a one molar portion of BaCO₃ and a three molar portion of CuO was ground with an agate mortar and pestle. The mixture was then heated in air at 900°C for more than 12 hours to obtain a uniform black BaCu₃O₄ powder.
   2. A yttrium wire was placed in a tube furnace for 12 hours at 500°C in flowing oxygen. After oxidation, the yttrium wire gave a resistance on the order of megaohms.
   3. The BaCu₃O₄ powder was put in a boat, and heated in a furnace to 1000°C for two hours. The powder was thereby melted. The yttrium wire was then dipped in the molten solution for 15 seconds, to coat the wire with same, and then removed.
   4. The coated yttrium wire was annealed for 12 hours at 900±5°C in flowing oxygen.

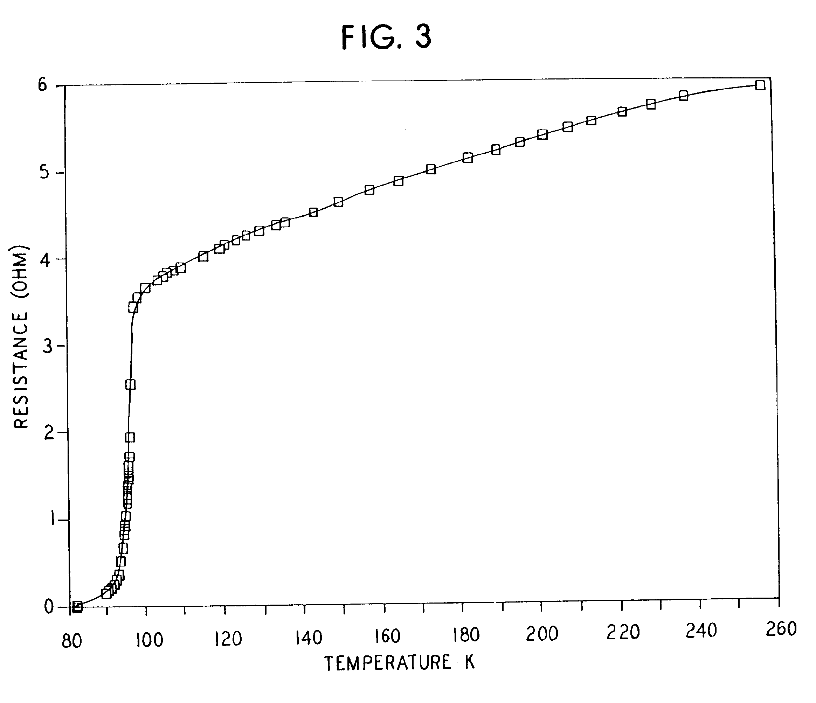

A wire prepared pursuant to this example formed a superconductive layer under the BaCu₃O₄ coating. Figure 3 illustrates, graphically, the resistance as a function of temperature for a Y-Ba-Cu-O wire made pursuant to this example. The resistance was measured at the BaCu₃O₄ and Y₂O₃ interface. The wire did not reach zero, but there was a sharp transition. Minimum resistance achieved for this wire was 0.02 ohms. The inventors of the present invention believe that this may have been due to silica contamination from the quartz boat which was used for the molten BaCu₃O₄.

## Claims

1. A process of preparing a superconducting wire, the process comprising contacting a metal wire comprising Y, Sm, Eu, Gd, Dy, Ho, Er, Tm, Yb, or Lu, that has been oxidised, with a barium-copper-oxide.

2. A process as claimed in claim 1 wherein the barium-copper-oxide is in a molten state to coat the metal wire and/or has the general formula:
BaₓCu_{y}O_{z}
wherein: 0<x<10; 0<y<10 and x+y-1<z<x+y+2.

3. A process as claimed in claim 1 or 2 wherein the molar ratio of barium to copper in the barium-copper-oxide is from 1:3 to 2:3.

4. A process as claimed in any of claims 1 to 3 additionally comprising annealing the metal wire.

5. A process as claimed in any of claims 1 to 3 comprising oxidising a metal wire where the metal is Y, Sm, Eu, Gd, Dy, Ho, Er, Tm, Yb or Lu; melting a barium-copper-oxide mixture; coating the oxidised metal wire with the molten barium-copper-oxide mixture.

6. A process as claimed in claim 5 additionally comprising grinding and mixing a mixture of BaCO₃ and CuO, or BaO and CuO, to create the barium-copper-oxide mixture.

7. A process as claimed in any of claims 2 to 6 additionally comprising scratching or etching a surface of the coated oxidised metal wire so that the metal oxide barium-copper-oxide interface layer can be accessed.

8. A superconducting wire comprising: a metal core wherein the metal is Y, Sm, Eu, Gd, Dy, Ho, Er, Tm, Yb or Lu; a metal oxide first layer; a barium-copper-oxide second layer outside the first layer; a superconducting layer located at an interface between the metal oxide layer and the barium-copper-oxide outer layer.

## Patentansprüche

1. Verfahren zur Herstellung eines supraleitenden Drahtes, umfassend das Inkontaktbringen eines oxidierten Y, Sm, Eu, Gd, Dy, Ho, Er, Tm, Yb oder Lu umfassenden Metalldrahtes mit einem Bariumkupferoxid.

2. Verfahren nach Anspruch 1, wobei das Bariumkupferoxid zur Beschichtung des Metalldrahtes im geschmolzenen Zustand vorliegt und/oder die allgemeine Formel aufweist:
BaₓCu_{y}O_{z}
in der: 0<x<10; 0<y<10 und x+y-1<z<x+y+2.

3. Verfahren nach Anspruch 1 oder 2, wobei das Molverhältnis von Barium zu Kupfer in dem Bariumkupferoxid 1:3 bis 2:3 beträgt.

4. Verfahren nach einem der Ansprüche 1 bis 3, zusätzlich Glühen des Metalldrahtes umfassend.

5. Verfahren nach einem der Ansprüche 1 bis 3, umfassend Oxidation eines Metalldrahtes, wobei das Metall Y, Sm, Eu, Gd, Dy, Ho, Er, Tm, Yb oder Lu ist; Schmelzen eines Barium-Kupferoxidgemisches und Beschichten des oxidierten Metalldrahtes mit dem geschmolzenen Bariumkupferoxidgemisch.

6. Verfahren nach Anspruch 5, zusätzlich umfassend Vermahlen und Vermischen eines Gemisches aus BaCO₃ und CuO oder BaO und CuO unter Herstellung des Bariumkupferoxidgemisches.

7. Verfahren nach einem der Ansprüche 2 bis 6, zusätzlich umfassend Ritzen oder Ätzen einer Oberfläche des beschichteten oxidierten Metalldrahtes derart, daß die Metalloxid-Bariumkupferoxid-Grenzschicht zugänglich werden kann.

8. Supraleitender Draht umfassend: einen Metallkern, wobei das Metall Y, Sm, Eu, Gd, Dy, Ho, Er, Tm, Yb oder Lu ist; eine erste Schicht aus einem Metalloxid; eine zweite Schicht aus einem Bariumkupferoxid außerhalb der ersten Schicht; eine supraleitende Schicht, angeordnet an der Grenzschicht zwischen Metalloxidschicht und der äußeren Bariumkupferoxidschicht.

## Revendications

1. Procédé pour la fabrication d'un fil supraconducteur, le procédé comprenant la mise en contact d'un fil métallique comprenant : Y, Sm, Eu, Gd, Dy, Ho, Er, Tm, Yb ou Lu, qui a été oxydé, avec un oxyde de baryum-cuivre.

2. Procédé selon la revendication 1, dans lequel l'oxyde de baryum-cuivre est à l'état fondu pour recouvrir le fil métallique et/ou correspond à la formule générale suivante :
BaₓCu_{y}O_{z}
où : 0 < x < 10 ; 0 < y < 10 et x + y - 1 < z < x + y + 2.

3. Procédé selon la revendication 1 ou 2, dans lequel le rapport molaire entre le baryum et le cuivre dans l'oxyde de baryum-cuivre est de 1:3 à 2:3.

4. Procédé selon l'une quelconque des revendications 1 à 3, comprenant de plus le recuit du fil métallique.

5. Procédé selon l'une quelconque des revendications 1 à 3, comprenant l'oxydation d'un fil métallique fabriqué en Y, Sm, Eu, Gd, Dy, Ho, Er, Tm, Yb ou Lu ; la fusion d'un mélange d'oxyde de baryum-cuivre ; le revêtement du fil métallique oxydé avec le mélange fondu d'oxyde de baryum-cuivre.

6. Procédé selon la revendication 5, comprenant en outre le broyage et le mélange d'un mélange de BaCO₃ et CuO, ou de BaO et CuO, pour préparer le mélange d'oxyde de baryum-cuivre.

7. Procédé selon l'une quelconque des revendications 2 à 6, comprenant en outre l'opération consistant à gratter ou à décaper une surface du fil métallique oxydé revêtu afin de pouvoir accéder à la couche d'interface entre l'oxyde métallique et l'oxyde de baryum-cuivre.

8. Fil supraconducteur comprenant : une âme métallique en Y, Sm, Eu, Gd, Dy, Ho, Er, Tm, Yb ou Lu ; une première couche d'oxyde métallique ; une seconde couche d'oxyde de baryum-cuivre à l'extérieur de la première couche ; une couche supraconductrice à l'interface entre la couche d'oxyde métallique et la couche extérieure d'oxyde de cuivre-baryum.
